# EUROPEAN PATENT SPECIFICATION

(11) **EP 2 363 511 B1**
(45) Date of publication and mention of the grant of the patent: **26.04.2017**
(21) Application number: 11154967.1
(22) Date of filing: 18.02.2011
(51) Int. Cl.: C23C 16/34, C23C 16/455, C23C 16/509, C23C 16/52, C23C 16/54, C23C 30/00

(54) **Film deposition method and film deposition device**
Filmabscheidungsverfahren und Filmabscheidungsvorrichtung
Procédé de dépôt de film et dispositif de dépôt de film

(30) Priority: 04.03.2010 JP 2010047633
(43) Date of publication of application: 07.09.2011
(73) Proprietor: Fujifilm Corporation, Minato-ku Tokyo (JP)
(72) Inventor: Nishida, Hiroyuki, Kanagawa (JP)
(74) Representative: Hoffmann Eitle

(56) References cited:
- EP-A1- 1 921 180
- EP-A1- 2 045 355
- EP-A1- 2 045 356
- EP-A1- 2 113 310
- EP-A1- 2 290 127
- WO-A2-2011/006018
- JP-A- 7 321 200

## Description

### BACKGROUND OF THE INVENTION

The present invention relates to a film deposition method and device suitable for producing a gas barrier film comprising a silicon nitride layer as a gas barrier layer.

A gas barrier film formed by depositing a gas barrier layer (a water-vapor barrier layer) on a base film is used not only in such positions or parts requiring moisture resistance in various devices including optical devices, displays such as liquid-crystal displays and organic EL displays, semiconductor manufacturing devices, and thin-film solar cells, but also in packaging materials used to package food, clothing, electronic components, and the like.

Among known gas barrier layers are those formed of various materials such as silicon oxide, silicon oxynitride, and aluminum oxide. An example of such known gas barrier layers is a silicon nitride layer composed primarily of silicon nitride (SiN). Known methods of producing a gas barrier layer composed primarily of silicon nitride include plasma-enhanced CVD.

In addition to excellent gas barrier properties, gas barrier layers are required to possess various other characteristics according to the performance required of gas barrier films, applications for which they are intended, and the like. Such required characteristics include, for example, excellent adhesion to the base film and excellent productivity, high resistance to deterioration caused by moisture, i.e., high resistance to oxidation, and little damage done to the base film during film deposition.

To meet such various requirements, gas barrier layers each having different characteristics are laminated to form a single gas barrier layer as is practiced in the art.

For example, JP 2002-105649 A describes a film deposition device comprising a feed chamber and a take-up chamber for feeding and rewinding an elongated base film in the form of a web, and a film deposition chamber provided between these chambers for depositing a layer on a base film under vacuum in the film deposition chamber, wherein the film deposition chamber includes a plurality of film deposition means including those using plasma-enhanced CVD method, and wherein a material gas (process gas) supply section is provided in each of film deposition sections comprising film deposition means and separated by insulation partitions.

This film deposition device achieves deposition of a gas barrier layer composed of different kinds of layers by changing the kind of material gas supplied to the film deposition sections and permits adjustment of film quality by adjusting the distance between the partitions.

JP 2009-31612 A describes a gas barrier layer composed of a first silicon nitride layer (SiN layer) formed by CVD at a starting temperature of 50°C or higher (preferably higher than 170°C) and a second silicon nitride layer deposited on the first silicon nitride layer by CVD at a starting temperature of 170°C or lower.

The gas barrier layer described in JP 2009-31612 A excels in peel strength with respect to the resin base film as well as gas barrier properties.

EP 1 921 180 A1 discloses a plasma discharge treatment apparatus by which a surface of a substrate continuously conveyed between a winder (roll-up-shaft) and an unwinder (roll-out shaft) is plasma-discharge-treated at atmospheric pressure or approximately atmospheric pressure, comprising two facing electrodes, at least one of which is a cylindrical electrode; at least two nip rollers fitted with the cylindrical electrode as back-up roller; a discharge section formed between the two nip rollers and also between the two facing electrodes; a device of supplying a reactive gas at atmospheric pressure or approximately atmospheric pressure, fitted into the discharge section; a device of emitting an exhaust gas after treatment; and a device of applying a voltage between the two facing electrodes, the plasma discharge treatment apparatus comprising the steps of:
supplying a reactive gas in the discharge section with the device of supplying the reactive gas; applying a voltage between the two facing electrodes to generate plasma discharge; and conducting a plasma discharge treatment onto a substrate surface passing through the discharge section, being brought into contact with the cylindrical electrode,
wherein rollers brought into contact with the treated substrate surface, and provided between the winder and the unwinder consist of nip rollers provided on the cylindrical electrode.

EP 2 290 127 A1 describes a film deposition device in which film deposition is performed on an elongated substrate which is traveling in a longitudinal direction, the film deposition device comprising:
a CVD film forming room disposed on a travel path of said substrate, including a material gas supply means and a first evacuation means and having a function of performing the film deposition on said substrate by CVD; a treatment room disposed upstream or downstream of said CVD film forming room on the travel path, including a second evacuation means and having a function of performing a predetermined treatment on said substrate; and a differential room disposed between and communicating with said CVD film forming room and said treatment room on said travel path, wherein said differential room includes a third evacuation means, a gas introducing means for introducing at least one of a gas to be supplied to both of said CVD film forming room and said treatment room, and an inert gas, and a control means which controls said third evacuation means and said gas introducing means to keep said differential room at a higher pressure than said CVD film forming room or said treatment room.

### SUMMARY OF THE INVENTION

However, because the film deposition device described in JP 2002-105649 A requires a plurality of film deposition means and film deposition sections to form a plurality of layers having different properties, the whole device necessarily assumes increased dimensions.

On the other hand, because the gas barrier layer described in JP 2009-31612 A includes the first silicon oxide film that is formed at a temperature of 170°C or higher, the starting temperature for film deposition is limited depending on the resin base film used. Therefore, there are cases where deposition of a dense silicon nitride layer having sufficient gas barrier properties and oxidation resistance may not be achieved.

In addition, quickly changing the base film temperature is extremely difficult. Accordingly, deposition of a gas barrier layer as described in the JP 2009-31612 A involving only a single rewind necessarily requires a plurality of film deposition means (film deposition sections) as in the film deposition device described in JP 2002-105649 A. In addition, a sufficient interval for adjusting the base film temperature is required between the operations of the film deposition means depending on the starting temperature for depositing the second silicon nitride layer.

Further, there are cases where the gas barrier layers described in JP 2002-105649 A and JP 2009-31612 A do not have sufficient film coating properties (coverage properties) during deposition of the first layer. Thus, when the base film has a highly coarse surface or foreign substances on its surface, a layer to be deposited is required to have a sufficient thickness depending on the irregularities of the surface. As a result, the productivity may decrease.

Further, where plasma-enhanced CVD is used for deposition of the first layer, plasma may damage and roughen the surface of the base film and this may adversely affect the characteristics of the gas barrier layer and hence the gas barrier film produced.

An object is to overcome the above problems associated with the prior art and provide a gas barrier film produced by depositing thereon a silicon nitride layer excelling in not only gas barrier properties but coverage capability for sufficiently coating the coarse surface of the base film and reduced damage to the base film during film deposition, as well as oxidation resistance and an optimum film deposition method of producing the gas barrier film, as well as a film deposition device.

A film deposition method according to the present invention comprises the steps claimed in claim 1.

A film deposition device according to the present invention comprises the features as claimed in claim 6.

### BRIEF DESCRIPTION OF THE DRAWINGS

Fig. 1 is a schematic view showing a gas barrier film as described herein.
Fig. 2 is a graph schematically showing distributions of the density of a silicon nitride layer formed in a gas barrier film as described herein and of a conventional gas barrier film.
Fig. 3 is a schematic view showing a film deposition device of the invention for implementing the film deposition method.
Figs. 4A to 4C illustrate examples of material gas flow creating means which can be used in the film deposition device shown in Fig. 3.
Figs. 5A to 5C are schematic views for explaining the differences in base film coverage properties due to the difference in silane radicals.

### DETAILED DESCRIPTION OF THE INVENTION

Now, the film deposition method, and a film deposition device according to the present invention will be described in detail below referring to the accompanying drawings.

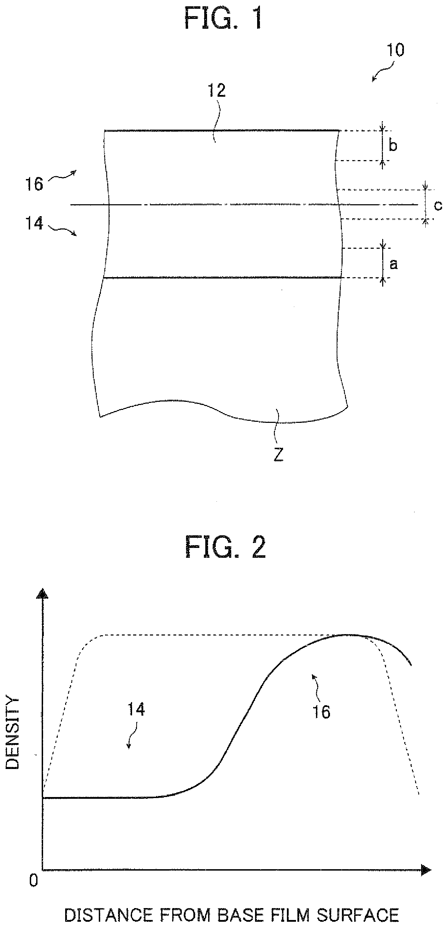

FIG. 1 is a schematic view showing a gas barrier film 10 as described herein.

As illustrated in Fig. 1, the gas barrier film 10 is formed by depositing a silicon nitride layer 12 as gas barrier layer on a base film Z.

In the gas barrier film 10, the base film Z is not specifically limited and may be any of sheet materials of various kinds that allow the silicon nitride layer 12 to be deposited by plasma-enhanced CVD.

Specific examples of the base film Z that may be advantageously used include plastic films (resin films) made of organic materials such as polyethylene terephthalate, polyethylene naphthalate (PEN), polyethylene, polypropylene, polystyrene, polyamide, polyvinyl chloride, polycarbonate, polyacrylonitrile, polyimide, polyacrylate, and polymethacrylate.

The base film Z may also be any of sheet materials formed of a base material such as any of those plastic films and a layer deposited thereon for imparting various functions, such as a protective layer, an adhesive layer, a light-reflecting layer, a light-shielding layer, a planarizing layer, a buffer layer, and a stress-relief layer.

The base film Z may be a sheet material having a single layer formed on a base material or a sheet material having a plurality of layers deposited on a base material. When the base film Z is a sheet material having a plurality of layers deposited on a base material, the same layer may be deposited in a plurality of layers or one or more layers may be silicon nitride layers that are deposited by the film deposition method (device) of the invention.

The gas barrier film 10 has a silicon nitride layer 12 formed on the surface of the base film Z.

The silicon nitride layer 12 comprises a low-density region 14 in a lower position closer to the base film Z deposited in the presence of a great proportion of SiH₃ radicals and a high density region 16 having a high density in an upper position closer to the top side opposite from the base film Z deposited in the presence of a great proportion of SiH₂ radicals.

Specifically, in the gas barrier film 10 described herein, a lower region having a thickness of 20% indicated by arrow a in Fig. 1 has a mean density lower than the mean density of an upper region closer to the top side having a thickness of 20% indicated by arrow b, and a middle region having a thickness of 20% indicated by arrow c has a mean density between those of the lower and the upper regions a and b. There may be cases where the interfaces between the adjacent regions of the silicon nitride layer 12 depending on the surface roughness of the base film Z may not be clear.

In such cases, the variation in composition in the film thickness direction may be measured by ESCA (Electron Spectroscopy for Chemical Analysis) to determine interfaces between adjacent layers where the N composition decreases and settles at a minimum and where the Si composition increases and settles at a maximum, and the interfaces thus determined may be used to detect the mean densities of the lower 20%-thickness layer, the upper 20%-thickness layer, and the middle 20%-thickness layer of the silicon nitride layer 12.

A typical silicon nitride layer is formed in the presence of a relatively great proportion of SiH₂ radicals in a middle region in the thickness direction whereas it is formed in the presence of a relatively great proportion of SiH₃ radicals in a top surface region and a lower region. Accordingly, the density of a typical silicon nitride layer is high in the middle region in the thickness direction and low in the top surface region and the lower region as conceptually shown by the dotted line in Fig. 2. The middle region in the thickness direction has a substantially consistent density therein.

By contrast, the gas barrier film 10 described herein has a composition such that, as indicated by the solid line in Fig. 2, the low density region 14 in a lower position deposited in the presence of a great proportion of SiH₃ radicals and the high density region 16 having a high density in a position closer to the top surface deposited in the presence of a great proportion of SiH₂ radicals, the middle region between them having a density between those of the lower and upper positions. With the deposited layer having such a composition, the production of the gas barrier film 10 excells not only in productivity and gas barrier properties but oxidation resistance as well, with significantly reduced damage caused to the base film Z.

These features will be described later in further detail.

The thickness of the silicon nitride layer 12 may be appropriately determined without any specific limitation according to such conditions as gas barrier properties and flexibility required of gas barrier films, applications for which the use of the film is intended, and the like, and is preferably 10 µm or more.

The silicon nitride layer 12 preferably has a mean density of 1.7 to 2.1 [g/cm³] in the 20%-tick lower region a and a mean density of 2.1 to 2.7 [g/cm³] in the 20%-thick upper region b as shown in Fig. 1.

Setting the mean densities of both regions in the above respective ranges permits obtaining improved coverage properties and achieving reduced damage to the surface of the base film during film deposition as well as obtaining sufficient gas barrier properties.

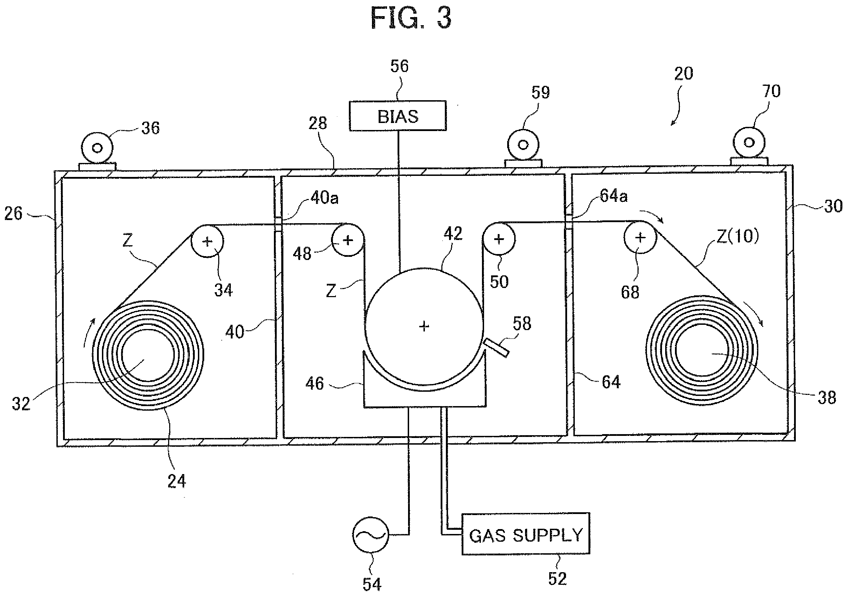

Fig. 3 schematically shows a film deposition device 20 for implementing a film deposition method to produce the gas barrier film 10.

The illustrated film deposition device 20 produces the gas barrier film 10 by depositing or forming the silicon nitride layer 12 by CCP (capacitively coupled plasma)-CVD on the surface of a long length of base film Z or a film material in the form of a web as it is transported in a longitudinal direction.

The film deposition device 20 is a so-called roll-to-roll (R-to-R) type film deposition device whereby the base film Z is fed from a base film roll 24, a roll of elongated base film Z, the silicon nitride layer 12 is formed on the base film Z traveling in the longitudinal direction, and the base film Z having the silicon nitride layer 12 formed thereon, that is, the gas barrier film 10, is rewound into a roll.

While a long length of sheet material as illustrated is a preferred example of the base film Z in the film deposition device 20 (film deposition method) of the invention, cut sheets cut to a given length may also be preferably used.

While the illustrated film deposition device 20 achieves deposition of the silicon nitride layer 12 by CCP-CVD, the present invention is not limited this way. Specifically, the invention permits use of various film deposition methods including ICP (Inductively Coupled Plasma)-CVD, microwave CVD, ECR (Electron Cyclotron Resonance), and atmospheric pressure plasma CVD, provided that the material gas flow is formed in the opposite direction to the base film transportation direction.

Among others, illustrated CCP-CVD described later may be advantageously used as it uses shower head electrodes 46 having a plane opposite the base film Z to readily achieve formation of gas flow in film deposition region in the opposite direction to the base film transportation direction.

As described above, the film deposition device 20 shown in Fig. 3 is a so-called roll-to-roll film deposition device whereby the base film Z is fed from the base film roll 24, which is a roll of elongated base film Z, and the silicon nitride layer 12 is formed on the base film Z traveling in the longitudinal direction before being rewound into a roll. The film deposition device 20 includes a feed chamber 26, a film deposition chamber 28 and a take-up chamber 30.

In addition to the illustrated members, the film deposition device 20 may also have various members of a roll-to-roll type device achieving film deposition by plasma CVD including various sensors, and various members (transport means) for transporting the base film Z along a predetermined path, as exemplified by a transport roller pair and a guide member for regulating the position in the width direction of the base film Z. In addition, the production device 10 may include a plurality of the same or different plasma CVD film deposition chambers.

The feed chamber 26 includes a rotary shaft 32, a guide roller 34 and a vacuum evacuation means 36.

The base film roll 24 into which a long length of base film Z is wound is mounted on the rotary shaft 32 in the feed chamber 26.

Upon mounting of the base film roll 24 on the rotary shaft 32, the base film Z travels along a predetermined travel path starting from the feed chamber 26 and passing through the film deposition chamber 28 to reach a take-up shaft 38 of the take-up chamber 30.

Feeding of the base film Z from the base film roll 24 and winding of the base film Z on the take-up shaft 38 in the take-up chamber 30 are carried out in synchronism in the film deposition device 20 to continuously form the silicon nitride layer 12 on the elongated base film Z in the film deposition chamber 28 by CCP-CVD as the base film Z travels in its longitudinal direction along the predetermined travel path.

In the feed chamber 26, the rotary shaft 32 is rotated by a drive source (not shown) in a clockwise direction in FIG. 1 so that the base film Z is fed from the base film roll 24, is guided by the guide roller 34 along the predetermined path and passes through a slit 40a provided in a partition wall 40 to reach the film deposition chamber 28.

In the preferred embodiment of the illustrated film deposition device 20, the feed chamber 26 and the take-up chamber 30 are provided with vacuum evacuation means 36 and 70, respectively. The vacuum evacuation means are provided in these chambers to ensure that these chambers have the same pressure (degree of vacuum) during film deposition as the film deposition chamber 28 described later so that the pressures inside these neighboring chambers do not affect the degree of vacuum inside the film deposition chamber 28 (deposition of the silicon nitride layer 12).

The vacuum evacuation means 36 is not particularly limited, and exemplary means that may be used include vacuum pumps such as a turbo pump, a mechanical booster pump, a dry pump, and a rotary pump, an assist means such as a cryogenic coil, and various other known (vacuum) evacuation means which use a means for adjusting the ultimate degree of vacuum or the amount of air discharged and are employed in vacuum deposition devices. In this regard, the same holds true for other vacuum evacuation means 59 and 70.

As described above, the base film Z is guided by the guide roller 34 to reach the film deposition chamber 28 through the slit 40a of the partition wall 40.

The film deposition chamber 28 is provided to deposit or form the silicon nitride layer 12 on the surface of the base film Z by CCP-CVD. In the illustrated embodiment, the film deposition chamber 28 includes a drum 42, a shower head electrode 46, guide rollers 48 and 50, a gas supply means 52, an RF power source 54, a bias current source 56, a gas stop means 58, and the vacuum evacuation means 59.

The drum 42 in the film deposition chamber 28 is a cylindrical member rotating counterclockwise about the central axis in Fig. 1, and the base film Z guided by the guide roller 48 along the predetermined path is passed over a predetermined region of the peripheral surface to travel onward in the longitudinal direction as the base film Z is held in a given position facing the shower head electrode 46 to be described later.

The drum 42 also serves as a counter electrode in CCP-CVD and forms a pair of electrodes with the shower head electrode 46.

Therefore, the drum 42 is connected with the bias current source 56. The bias current source 56 may be any of various known current sources used as bias current source for CCP-CVD such as a 400 kHz RF current source.

The present invention is not limited this way, however. The drum 42 may be connected to ground or may be selectively connected to ground and the bias power source 56.

While the illustrated example comprises the RF power source 54 for supplying plasma excitation current to the shower head electrode 46 described later, the present invention is not limited this way. Specifically, the RF power source 54 for supplying plasma excitation current may be connected to the drum 42, with the shower head electrode 46 connected to ground, to achieve film deposition by so-called self-bias type CCP-CVD. Alternatively, the drum 42 may be connected with the RF power source 54, with the shower head electrode 46 connected to the bias power source 56. Alternatively, the drum 42 may be connected to the RF power source 54, with the shower head electrode 46 selectively connected to the bias power source 56 or ground.

Further, film deposition according to the invention is preferably carried out while adjusting the temperature of the base film Z (heating/cooling). Therefore, drum 42 preferably comprises a temperature adjusting means.

The temperature adjusting means of the drum 42 is not particularly limited and various types of temperature adjusting means may be used including one containing a refrigerant or a heating agent circulating in the drum and a cooling means using a piezoelectric element.

The shower head electrode 46 is of a known type used in film deposition by means of CCP-CVD.

In the illustrated example, the shower head electrode 46 is, by way of example, hollow and has a substantially rectangular shape, with one external plane thereof being inwardly curved into a shape forming a part of the inner periphery of a cylinder having a radius greater than that of the drum 42. The shower head electrode 46 is so disposed that the rotation axis of the drum 42 and the central axis of the curved plane coincide to keep the curved plane away from the opposite periphery of the drum 42 by the same distance throughout the curved plane. In other words, the difference in radius between them corresponds to the distance separating them, so that the gap between them remains constant.

The curved plane of the shower head electrode 46 has numerous through-holes for emitting a material gas evenly distributed in the whole area of a region that has at least a chance of facing the base film Z.

The shower head electrode 46 has a length in the drum axial direction (i.e., the direction normal to the base film transporting direction, which will also be referred to below as "width-wise" direction) exceeding a maximum width of the base film Z and preferably slightly exceeding the size of the drum 42 in the width direction.

Further, the shower head electrode 46 may comprise a wall-like shield member at its upstream end for preventing emission of a material gas from the gap between the upstream end of the shower head electrode 46 and the drum 42.

The shower head electrode 46 according to the invention is not limited to the illustrated type having the curved plane and may be hollow and have a rectangular shape (hollow plate member) or may have a curved shape not parallel to the periphery of the drum.

Thus, the present invention allows any of known shower head electrodes used in CCP-CVD.

In the illustrated example, one shower head electrode (film deposition means using CCP-CVD) is provided in the film deposition chamber 28. However, the present invention is not limited to this configuration and a plurality of shower head electrodes may be disposed in the base film transport direction.

Further, the present invention is not limited to a configuration using the shower head electrode and allows a configuration comprising nozzles or the like for supplying a material gas provided between an electrode without the material gas emission holes (material gas supply means) and the other electrode to achieve CCP-CVD.

The gas supply means 52 is of a known type used in vacuum deposition plasma CVD devices, and supplies a material gas (process gas) into the shower head electrode 46. As described above, a large number of through holes are formed in the surface (curved plane) of the shower head electrode 46 facing the drum 42. Therefore, the material gas supplied into the shower head electrode 46 passes through the through holes to be introduced into the space between the shower head electrode 46 and the drum 42.

The film deposition device 20 (film deposition method) of the invention uses material gas containing a gas forproducing silane radicals (SiH₃ and SiH₄) to achieve deposition of the silicon nitride layer 12.

Preferred gases for producing silane radicals may be selected from various silane gases.

Examples of such gases include silane [SiH₄], monomethyl silane [MMS CH₃SiH₃], dimethyl silane [DMS (CH₃)₂SiH₂)], trimethyl silane [(CH₃)₃SiH], tetramethyl silane [TMS (CH₃)₄Si], tetraethoxysilane [TEOS (C₂H₅O)₄Si], triethoxysilane [TRIES (C₂H₅O)3SiH], methyl triethoxysilane [(C₂H₅O)₃SiCH₃], dimethyl diethoxysilane [(C₂H₅O)₂Si(CH₃)₂], tetramethoxysilane [(CH₃O)₄Si], diethyl silane [(C₂H₅)₂SiH₂], triethyl silane [(C₂H₅)₃SiH], diethoxymethyl silane [(C₂H₅O)₂SiH(CH₃)], methyl trimethoxysilane [(CH₃O)₃SiCH₃], dimethyl dimethoxysilane [(CH₃O)₂Si(CH₃)₂], methyl trichlorosilane [CH₃SiCl₃], methyl dichlorosilane [(CH₃)HSiCl₂], dimethyl dichlorosilane [DDMS (CH₃)₂SiCl₂], trimethyl chlorosilane [TMCS (CH₃)₃SiCl], dichloroethyl silane [(C₂H₅)HSiCl₂], bis tertiary-butyl amino silane [BTBAS], HMDSO [(CH₃)₃SiOSi(CH₃)₃], and fluoroalkyl silane

The gas supply means 52 feed a material gas containing one or more of these gases to the shower head electrode 46.

The material gas that may be any of various gases as appropriate including a known gas used for deposition of a silicon nitride layer using gas that produces the above-mentioned silane radicals and a combination of gases.

Examples of the material gas include a combination of silane gas, ammonia gas, and hydrogen gas; a combination of silane gas, ammonia gas, nitrogen gas, and hydrogen gas; a combination of silane gas and ammonia gas; a combination of silane gas and nitrogen gas; and any of these combinations to which helium or argon is added as diluent gas.

The RF power source 54 is one for supplying plasma excitation power to the shower head electrode 46. Known RF power sources used in various plasma CVD devices can be all used for the RF power source 54 including a power source that supplies 13.56 MHz RF electricity.

As described above, the present invention permits use of various configurations in addition to one where the shower head electrode 46 is supplied with plasma excitation current, one example thereof being a self bias type where the drum 42 is supplied with plasma excitation current while the shower head electrode 46 is connected to ground.

The vacuum evacuation means 59 evacuates the film deposition chamber 14 to keep it at a predetermined film deposition pressure for deposition of the silicon nitride layer 12 by plasma-enhanced CVD, and is of a known type used in vacuum deposition devices as described above.

The film deposition chamber 28 comprises the gas shield means 58 adjacent a downstream end of the shower head electrode 46 in the base film transport direction. Hereinafter, the downstream in the base film transport direction is also referred to simply as downstream, and the opposite stream as upstream.

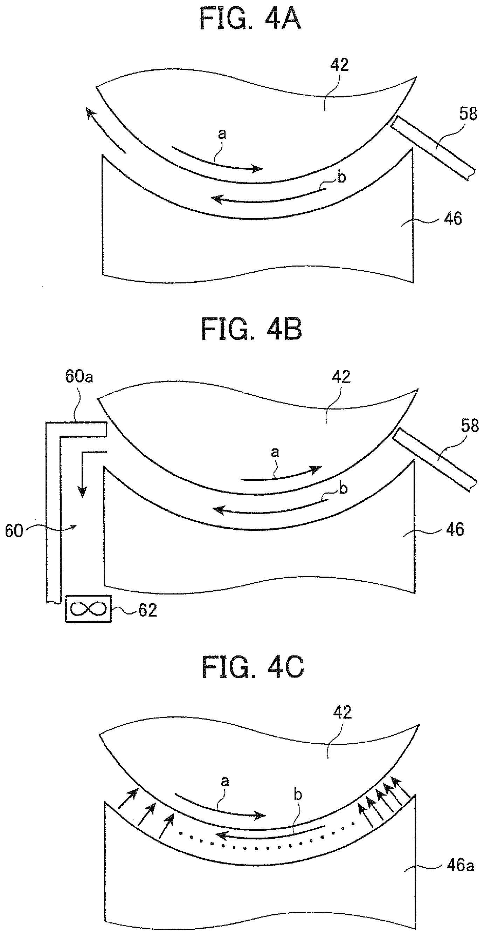

The gas shield means 58 is a sheet member disposed with an end thereof as close to the drum 42 and a plane thereof as close to the downstream end of the shower head electrode 46 as the configuration permits, as schematically illustrated in Fig. 4A by way of example. The gas shield means 58 has a width-wise length longer than the shorter of the width-wise sizes of the drum 42 and the shower head electrode 46.

The gas shield means 58 may be disposed in contact with the shower head electrode 46. The gas shield means 58 may be provided in the shower head electrode 46.

Thus, the gas blocking means 58 substantially closes the gap between the shower head electrode 46 and the drum 42 at the downstream end of the shower head electrode 46 to prevent the material gas from discharging from this position.

The film deposition chamber 28 equipped with the gas blocking means 58 allows a gas flow of the material gas (also referred to below simply as material gas flow) to be created in the direction indicated by arrow b, which is the opposite direction to the base film transport direction (direction in which the drum 42 turns) indicated by arrow a in Fig. 4, in the film deposition region, which is the region where the shower head electrode 46 and the drum 42 face each other in the illustrated example.

According to the film deposition device 20 (film deposition method), the silicon nitride layer 12 is deposited on the surface of the base film by plasma-enhanced CVD as the base film Z is transported while the material gas flow is formed in the opposite direction to the base film transport direction, as described above.

Provided with such a configuration, the present invention enables production of the gas barrier film 10 of the invention having the silicon nitride layer 12 deposited thereon comprising the lower low-density region 14 and the upper high-density region closer to the top surface and causing minimized damage to the base film Z, enabling a high productivity, and excelling in gas barrier properties and oxidation resistance with a single deposition means. When, by way of example, the CCP-DVD as illustrated is used, the gas barrier film 10 of the invention can be produced with a pair of electrodes consisting of a gas material supply means and another electrode.

In the deposition of a silicon nitride layer by plasma-enhanced CVD using, for example, silane as material gas, plasma produces silane radicals, which reacts with nitrogen radicals (nitrogen containing radicals) produced from other material gases to form a silicon nitride layer.

The silane radicals thus produced are primarily SiH₂ radials and SiH₃ radials. According to a study by the present inventors, a silicon nitride layer produced in the presence of SiH₂ radicals existing in a great proportion in the silicon nitride layer deposition process accompanied by production of silane radicals has a high density and excels in gas barrier properties and oxidation resistance.

A silicon nitride layer produced in the presence of SiH₃ radicals existing in a great proportion in the silicon nitride layer deposition process accompanied by production of silane radicals excels in base film coverage (step coverage) capability and can adequately coat the base film surface even when the surface has significant irregularities, although the density is not so high compared with the above film. That is, the thickness of the layer for eliminating the adverse effects of the irregularities of the base film surface can be reduced, resulting in improved productivity. In addition, SiH₃ radicals produced by plasma only cause extremely small damage to the base film surface as compared with SiH₂ radicals.

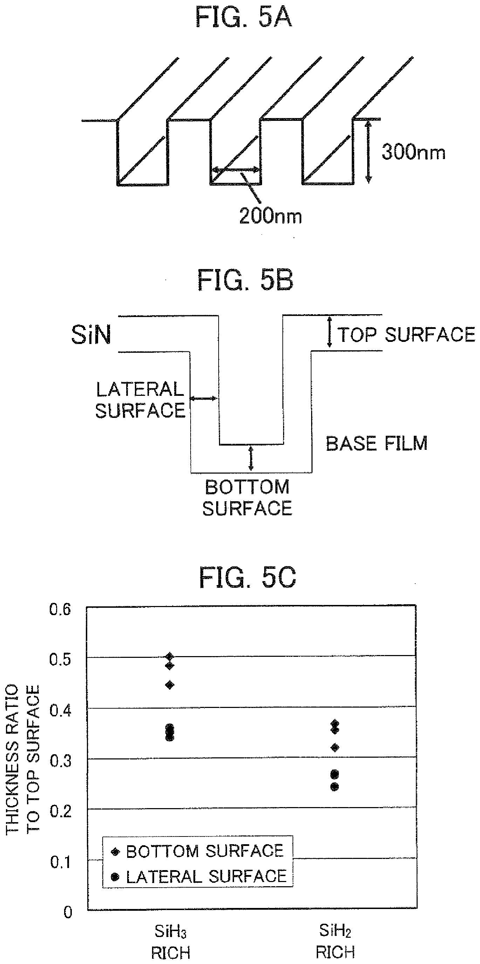

Fig. 5 shows base film coverage characteristics for comparison between film deposition in the presence of SiH₃ radicals existing in a great proportion (SiH₃ rich conditions) and film deposition in the presence of SiH₂ radicals existing in a great proportion (SiH₂ rich conditions).

In the comparison was used a trench base film as illustrated in Fig. 5A having corrugations each measuring 200 nm in width and 300 nm in height (depth). A silicon nitride layer was deposited on the trench base film under SiH₃ rich conditions and SiH₂ rich conditions to evaluate the base film coverage characteristics based on a ratio of the thickness of the film deposited on the lateral and bottom surfaces of the corrugations to the thickness of the film deposited on the top surface of the corrugations as conceptually illustrated in Fig. 5B. The material gas used was silane gas, ammonia gas, nitrogen gas and hydrogen. The electric current and gas flow rate were adjusted to provide SiH₃ rich and SiH₂ rich conditions.

The results given in Fig. 5C show that the film deposited under SiH₃-rich conditions has a thickness on both the lateral and bottom surfaces that are closer to the thickness thereof on the top surface as compared with the film deposited under SiH₂-rich conditions and excels the film deposited under SiH₂-rich conditions in base film coverage characteristics.

Accordingly, the gas barrier film 10 as described herein which comprises the silicon nitride layer 12 causing significantly reduced damage to the base film Z and excelling in not only productivity but gas barrier properties and oxidation resistance, with a lower low-density region 14 and a high-density region 16 closer to the top surface can be produced by first carrying out film deposition in the presence of SiH₃ radicals existing in a great proportion, followed by film deposition in the presence of SiH₂ radicals existing in a great proportion.

On the other hand, the study by the present inventors shows that when plasma exists in a high density, i.e., as the material gas exists in a great quantity, SiH₂ radicals tend to be readily produced, whereas as the density of plasma decreases, i.e., as the material gas is consumed, SiH₃ radicals tend to be produced with an increased readiness.

In silicon nitride layer deposition accompanied by generation of silane radicals, highly reactive SiH₂ radicals are consumed by film deposition earlier than SiH₃ radicals.

Further, SiH₂ radicals change into SiH₃ radicals as they hit other radicals or as time passes.

Accordingly, transporting the base film Z in a given direction indicated by arrow a in Fig. 4A and generating a material gas in the opposite direction indicated by arrow b to the base film transport direction causes SiH₂ radicals to be generated by high density plasma on the downstream side (upstream in the gas flow), increasing the proportion in which these radicals exist. Further, because SiH₂ radicals are consumed more readily for film deposition as described above, the amount of SiH₂ radicals, which are consumed earlier, decreases toward upstream (downstream in the gas flow), thus increasing the ratio of SiH₃ existing in the silane radicals. Further, the ratio of SiH₃ existing in the silane radicals increases toward upstream also because the chance of SiH₂ radicals changing into SiH₃ radicals increases from upstream to downstream.

Along the length of the transported base film Z, the material gas is used for deposition of the silicon nitride layer under conditions where SiH₃ radicals exist in a great proportion on the upstream side (in the starting stage of film deposition, in the lower position of the layer, i.e., in a position closer to the base film), and the proportion of SiH₃ radicals decreases toward the downstream side whereas the proportion of SiH₂ radicals gradually increases, so that the material gas is used for deposition of the silicon nitride layer under conditions where SiH₂ radicals exist in a great proportion on the downstream side (in the terminating stage of film deposition, in a position closer to the top surface).

Achieving silicon nitride layer deposition with concurrent base film transport and material gas flow, the present invention enables production, with a single deposition means using plasma-enhanced CVD, of the gas barrier film 10 of the invention having the silicon nitride layer 12 deposited thereon comprising the lower low-density region 14 and the upper high-density region closer to the top surface, with a density distribution such that the middle region having a mean density between those of the low-density region and the high-density region as shown by the solid line in Fig. 2 and having excellent properties described above. When, by way of example, the CCP-DVD as illustrated is used, the gas barrier film 10 of the invention can be produced with a pair of electrodes consisting of a gas material supply means and another electrode.

Thus, the production method of the invention achieves production of the gas barrier film 10 of the invention aiming at simplification of the device, reduction in size of the device, cost reduction, and the like. Further, the configuration needing only one film deposition means allows the film deposition means to be of larger dimensions than with a configuration requiring a plurality of film deposition means, thus enabling improvement on productivity.

The shower head electrode 46 is of a known type used in film deposition by means of CCP-CVD.

A typical shower head electrode 46 of this kind is so designed as to allow a material gas to reach the whole area of the film deposition region evenly. To that end, the material gas is allowed to flow both upstream and downstream from the center of the shower head electrode 46 with respect to the transport direction in film deposition by typical CCP-CVD that does not use the gas shield member 58. As a result, SiH₂ radicals exist in a greater proportion near the center whereas SiH₃ radicals exist in a greater proportion in regions close to the upstream and downstream ends. However, because the shower head electrode 46 supplies the material gas evenly throughout the whole film deposition region, the material gas flow is slow, and the difference in proportion in which both radicals exist in respective film deposition regions in the base film transport direction is not considerably great.

Thus, the silicon nitride layer produced by typical CCP-CVD has a high and uniform density in the middle region and a low density at both ends as indicated by the dotted line in Fig. 2.

The method of forming the material gas flow in the opposite direction to the base film transport direction according to the invention is not limited to the method illustrated in Fig. 4A and may be any of various methods as appropriate depending on the configuration of the film deposition device.

As illustrated in Fig. 4B, for example, a wall member 60a or the like may be provided in addition to the gas blocking means 58 to provide a gas discharge passage 60 for guiding material gas that was not used for reaction to an appropriate position. Where necessary, a suction means 62 such as a suction fan for sucking the material gas may be provided in a position along the gas discharge passage 60 or close to the outlet thereof).

Alternatively, the shower head electrode may have such a configuration wherein gas emission holes are provided downstream with a high density and upstream with a lower density than downstream so as to make a difference between upstream and downstream in the amount of introduced material gas thereby to create a material gas flow in the opposite direction to the transport direction (direction a) as in the shower head electrode 46a as illustrated in Fig. 4C in lieu of the shower head electrode 46 where the material gas emission holes are evenly distributed along the film deposition region. In such a configuration, the density of the emission holes may gradually decrease from downstream to upstream or the gas emission holes may be provided in a given upstream region, a given downstream region, and other regions of the shower head electrode with the densities decreasing from the downstream region through said other region to the upstream region. Alternatively, the gas emission holes may be provided only in a given downstream region.

Still alternatively, the inside of the shower head electrode, provided evenly with material gas emission holes, may be divided into regions, and the amounts of material gas supplied to these divided regions may be so adjusted as to make a difference in the amount of introduced material gas between upstream and downstream thereby to produce the material gas flow in the opposite direction to the transport direction.

Further, the above configurations may be combined as appropriate to produce the material gas flow in the opposite direction to the transport direction.

According to the invention, the film deposition conditions such as the material gas supply amount and the magnitude of the plasma excitation current are not specifically limited. The film deposition conditions may be determined as appropriate according to required film deposition speed, final film thickness, the kind of base film Z, and the like as in silicon nitride layer deposition using typical plasma-enhanced CVD. To adequately produce SiH₂ radicals, a certain level of plasma excitation power is required, preferably it is in a range of 1 W/cm² to 8 W/cm².

The material gas flow rate is also not specifically limited and may be determined as appropriate by conducting experiments and simulations under conditions according to the base film transport speed, required gas barrier film properties, and the like.

The difference in density between the low-density region 14 and the high-density region 16 can be adjusted by changing, for example, the material gas flow rate, base film Z transport speed, the length of the film deposition region (along the transport direction of the shower head electrode), supplied electric power, and the like.

As described above, the base film Z guided by the guide roller 48 is passed over the peripheral surface of the drum 42 and held in a given position as it is transported along the longitudinal direction. Between a pair of electrodes consisting of the drum 42 and the shower head electrode 46, plasma is excited as the shower head electrode 46 is supplied with plasma excitation power, whereupon the material gas yields radicals, and the silicon nitride layer 12 is deposited by CCP-CVD on the surface of the base film Z that, supported by the drum 42 and transported further onward.

The base film Z having the silicon nitride layer 12 deposited thereon (i.e., gas barrier film 10) is then guided by the guide roller 50 and transported through the slit 64a of the partition wall 64 to enter the take up chamber 30.

In the illustrated embodiment, the take-up chamber 30 includes the guide roller 68, the take-up shaft 38 and the vacuum evacuation means 70.

The base film Z (gas barrier film) having reached the take-up chamber 30 travels to the take-up shaft 38 as it is guided by the guide roller 58 and is wound on the take-up shaft 38 to form a roll, which is then supplied to the subsequent step as a roll of gas barrier film.

The take-up chamber 30 is also provided with the vacuum evacuation means 70 as in the above-described feed chamber 26 and during film deposition, its pressure is reduced to a degree of vacuum suitable for the film deposition pressure in the film deposition chamber 28.

The operation of the film deposition device 20 is described below.

Upon mounting of the base film roll 24 on the rotary shaft 32, the base film Z follows a given transport path as it is reeled out from the base film roll 24, travels from the feed chamber 26, and is guided by the guide roller 34 to reach the film deposition chamber 28, where the base film Z is guided by the guide roller 48, passed over a predetermined region of the peripheral surface of the drum 42 and guided by the guide roller 50 to reach the take-up chamber 30, where the base film Z is guided by a guide roller 68 to reach the take-up shaft 38.

Subsequently, the vacuum evacuation means 36, 59, and 70 are actuated to reduce the chambers to their given pressures.

When the degrees of vacuum in the chambers stabilize, the gas supply means 52 supplies the shower head electrode 46 with the material gas in the film deposition chamber 28.

When the pressure in the film deposition chamber 28 settles down to a given pressure for deposition of the silicon nitride layer 12 by CCP-CVD, the base film Z starts to be transported from the feed chamber 26 toward the take-up chamber 30 while the RF power source 54 starts to supply the shower head electrode 46 with plasma excitation power and, optionally, the bias current source 56 starts to supply the drum 42 with bias current.

The base film Z transported from the feed chamber 26 to the film deposition chamber 28 is guided by the guide roller 48 and transported onward as it is passed over the drum 42 while the silicon nitride layer 12 is deposited by CCP-CVD in the region where the drum 42 and the shower head electrode 46 face.

The film deposition chamber 26 comprises the gas shield means 58 at the downstream end of the shower head electrode 46 in the base film transport direction to prevent material gas discharge from the gap between the drum 42 and the shower head electrode 46. As a result, the material gas is caused to flow in the opposite direction to the transport direction, so that the silicon nitride layer 12 deposited comprises, as described above, the lower low-density region 14 and the upper high-density region closer to the top surface and exhibits a density distribution as indicated by the solid line in Fig. 2.

The base film Z having the silicon nitride layer 12 deposited thereon, i.e., gas barrier film 10, is then guided by the guide roller 50 and transported to the take-up chamber 30.

The base film Z having reached the take-up chamber 30 is guided by the guide roller 68 along a given path and rewound by the take-up shaft 30 into a roll, which is then supplied to the subsequent step as the gas barrier film 10.

While the film deposition device, and the film deposition method according to the present invention has been described above in detail, the present invention is by no means limited to the foregoing embodiments and it should be understood that various improvements and modifications may of course be made without departing from the scope of the invention.

### <Working Example 1>

The film deposition device 20 as illustrated in Fig. 3 was used to deposit a silicon nitride layer on the base film Z to produce a gas barrier film.

The base film Z used was a 100 µm-thick PEN film provided by Teijin DuPont Films Japan Limited.

The material gas used included silane gas (SiH₄), ammonia gas (NH₃), and hydrogen gas (H2). The supply amounts of silane gas, ammonia gas, and hydrogen gas were 200 sccm, 500 sccm, and 1200 sccm, respectively.

The shower head electrode 46 was supplied with plasma excitation power having a frequency of 13.5 MHz and an output of 2W/cm². The drum 42 was adjusted to a temperature of 40°C and supplied with a bias current having a frequency of 400 kHz and an output of 600 W.

The film deposition pressure was 20 Pa; the base film transport speed was 1 m/min.

Under the above film deposition conditions, the silicon nitride layer with a thickness of 50 nm was deposited on the surface of the base film Z to produce the gas barrier film 10.

The produced gas barrier film was measured by Rutherford backscattering/hydrogen forward scattering analysis (RBS/HFS) to determine the mean densities in the lower 20%-thickness region closer to the base film (indicated by arrow a in Fig. 1), the upper 20%-thickness region closer to the top surface (indicated by arrow b in Fig. 1), and the middle 20%-thickness region between them (indicated by arrow c in Fig. 1) of the silicon nitride layer 12.

The mean densities in the lower region, the upper region, and the middle region were 1.9 [g/cm³], 2.3 [g/cm³], and 2.1 [g/cm³], respectively.

### <Working Example 2>

A gas barrier film was produced in the same manner as in Working Example 1 except that
the shower head electrode 46 was connected to ground and not supplied with plasma excitation power whereas
the drum 42 was supplied with plasma excitation power having a frequency of 13.5 MHz and an output of 2W/cm² (self-bias configuration). The thickness of the silicon nitride layer 12 was 50 nm, which was the same as that in Working Example 1. The travel speed of the base film Z was set to 2 m/min.

The mean densities in the respective regions were measured in the same manner as in Working Example 1: the mean densities in the lower region, the top surface region, and the middle region were 2.0 [g/cm³], 2.4 [g/cm³], and 2.2 [g/cm³], respectively.

### <Comparative Example 1>

A gas barrier film was produced in the same manner as in Working Example 1 except that the gas shield member 58 was not provided. The thickness of the silicon nitride layer 12 was 50 nm, which was the same as that in Working Example 1.

The mean densities in the respective regions were measured in the same manner as in Working Example 1: the mean densities in the lower region, the top surface region, and the middle region were 2.3 [g/cm³], 2.3 [g/cm³], and 2.3 [g/cm³], respectively.

The gas barrier films thus produced were evaluated for base film coverage properties, gas barrier properties, damage to the base film, and oxidation resistance of the silicon nitride layer.

### [Base film coverage properties]

The trench base film illustrated in Fig. 5A was attached to the drum 42 and film deposition was carried out in the same manner as in Working Examples 1 and 2 and Comparative Example 1 to examine the base film coverage properties. The base film coverage properties were evaluated based on a ratio of the thickness of the film deposited on the bottom surface of the corrugations to the thickness of the film deposited on the top surface of the corrugations as in the case illustrated in Fig. 5C. Ratings were given as follows.

Excellent for a bottom-to-top surface thickness ratio greater than 0.42.

Good for a bottom-to-top surface thickness ratio in a range of 0.42 to 0.38.

Poor for a bottom-to-top surface thickness ratio of less than 0.38.

### [Gas Barrier Properties]

The moisture vapor transmission rate [g/(m²·day)] was measured by the MOCON method.

Those samples which exceeded the limit for measurement of the moisture vapor transmission rate by the MOCON method were measured for the moisture vapor transmission rate by the calcium corrosion method (see JP 2005-283561 A).

### [Base Film Damage Conditions]

The surface of the produced gas barrier films were scanned by an atomic force microscope (AFM) covering an area of 10 µm x 10 µm and their arithmetic mean roughness (Ra) was calculated to determine the damage conditions of the base film. Ratings were given as follows.
Excellent for Ra of less than 0.5 nm,
Good for Ra in a range of 0.5 nm to 2 nm, and
Poor for Ra of greater than 2 nm.

### [Oxidation Resistance]

The gas barrier film was subjected to a storage test in an environment of 85°C and 85%RH for 1000 hours. The composition of the layer before and after the storage was examined by X-ray photoelectron spectroscopy (abbreviated as XPS; Quantera SXM available from Ulvac-Phi, Incorporated) to evaluate the oxidation resistance of the film. The composition of the whole layer except the surfaces and interfaces that were already oxidized before the storage, i.e., a region lying in a thickness of 5 nm to 45 nm, was examined to evaluate the ratio of oxygen to nitrogen (O/N value) according to the following criteria.
Excellent when the difference between before and after storage is within ±3% (substantially no change);
Good when the ratio increase from before to after the storage is less than 10%; and
Poor when the ratio increase from before to after the storage is 10% or more.

The results are shown in Table 1.

**Table 1**

| | Mean density [g/cm³] | | | Coverage properties | Gas barrier properties | Minimized damage to base film | Oxidation resistance |
|---|---|---|---|---|---|---|---|
| | lower | middle | upper | | | | |
| Working Example 1 | 1.9 | 2.1 | 2.3 | Good | <1×10⁻⁴ | Excellent | Excellent |
| Working Example 2 | 2.0 | 2.2 | 2.4 | Excellent | <1×10⁻⁴ | Good | Excellent |
| Comparative Example 1 | 2.3 | 2.3 | 2.3 | Poor | >1×10⁻³ | Poor | Poor |

As shown in Table 1, the gas barrier film of the invention produced by the production device (method) according to the invention excels the comparative examples produced by conventional methods in all of base film coverage properties, gas barrier properties, minimizing of damage to the base film, and oxidation resistance.

The above results clearly show the beneficial effects of the present invention.

### Industrial Applicability

The present invention may be advantageously applied to gas barrier films used in various displays such as liquid crystal displays, solar cells, and the like and to production of these gas barrier films.

## Claims

1. A film deposition method comprising the steps of:
transporting a base film (Z) in a given direction;
introducing a material gas containing a gas that generates silane radicals while creating gas flow of the material gas in the opposite direction as the base film transport direction; and
depositing a silicon nitride layer (12) on a surface of the base film by plasma-enhanced CVD,
wherein the gas flow is created by providing a blocking means (58) of blocking the material gas flow on the downstream side of a material gas introducing portion in relation to the base film transport direction,
wherein the gas flow is created by introducing more material gas downstream side in relation to the base film transport direction than upstream side.

2. The film deposition method according to Claim 1, wherein the silicon nitride layer (12) is deposited by CCP-CVD.

3. The film deposition method according to Claim 2, wherein the material gas is introduced through a shower head electrode (46, 46a) having a plurality of gas emission holes.

4. The film deposition method according to any one of Claims 1 to 3, wherein the gas flow is created by providing a discharge passage (60) for discharging the material gas on the upstream side of a material gas introducing portion (46, 46a) in relation to the base film transport direction.

5. The film deposition method according to any one of claims 1 to 4, wherein the film deposition is achieved while a long length of base film (Z) is transported in a longitudinal direction.

6. A film deposition device (20) comprising:
a transport means (34, 42, 48, 50, 68) of transporting a base film (Z);
a film deposition means including a material gas introduction means (52) of introducing a material gas containing a gas that generates silane radicals and a plasma generating means (54); and
a gas flow creating means (58) for creating a material gas flow in the opposite direction as a transport direction of the base film,
a silicon nitride layer being deposited on a surface of the base film by plasma-enhanced CVD,
wherein the gas flow creating means includes a material gas blocking means (58) provided on the downstream side of the material gas introduction means in relation to the base film transport direction,
wherein the material gas introduction means also acts as the gas flow creating means and wherein the gas flow is created by introducing more material gas downstream side in relation to the base film transport direction than upstream side.

7. The film deposition device (20) according to Claim 6, wherein the plasma generating means (54) includes a pair of electrodes.

8. The film deposition device (20) according to Claim 7, wherein one of the pair of the electrodes is a shower head electrode (46, 46a) having a plurality of gas emission holes for the material gas.

9. The film deposition device according to any one of Claims 6 to 8, wherein the gas flow creating means includes a discharge passage (60) for discharging the material gas on the upstream side of a material gas introduction means in relation to the base film transport direction.

10. The film deposition device according to any one of Claims 6 to 9, wherein the transport means includes a cylindrical drum (42) over a peripheral surface of which a long length of base film (Z) is passed to transport the base film in a longitudinal direction thereof.

## Patentansprüche

1. Filmabscheidungsverfahren, umfassend die Schritte:
Transportieren einer Basisfolie (Z) in eine gegebene Richtung;
Einführen eines Materialgases, das ein Gas enthält, das Silanradikale bildet, während verursacht wird, dass der Gasfluss des Materialgases in die entgegengesetzte Richtung zur Basisfolien-Transportrichtung fließt; und
Abscheiden einer Siliciumnitridschicht (12) auf einer Oberfläche der Basisfolie durch plasmaverstärkte CVD,
worin der Gasfluss verursacht wird, indem ein Blockiermittel (58) zum Blockieren des Materialgasflusses vorgesehen wird auf der nachgeschalteten Seite eines Materialgas-Einführbereichs, in Relation zu der Basisfolien-Transportrichtung,
worin der Gasfluss durch Einführen von mehr Materialgas auf der nachgeschalteten Seite in Bezug auf die Basisfolien-Transportrichtung als auf der vorgeschalteten Seite herbeigeführt wird.

2. Filmabscheidungsverfahren gemäß Anspruch 1, worin die Siliciumnitridschicht (12) durch CCP-CVD abgeschieden wird.

3. Filmabscheidungsverfahren gemäß Anspruch 2, worin das Materialgas durch eine Duschkopfelektrode (46, 46a) mit einer Vielzahl von Gasemissionslöchern eingeführt wird.

4. Filmabscheidungsverfahren gemäß irgend einem der Ansprüche 1 bis 3, worin der Gasfluss verursacht wird, in dem eine Auslasspassage (60) zum Ausführen des Materialgases auf der vorgeschalteten Seite des Materialgas-Einführbereichs (46, 46a) im Hinblick auf die Basisfolien-Transportrichtung vorgesehen wird.

5. Filmabscheidungsverfahren gemäß irgendeinem der Ansprüche 1 bis 4, worin die Filmabscheidung erreicht wird, während eine lange Länge der Basisfolie (Z) in einer Längsrichtung transportiert wird.

6. Filmabscheidungsvorrichtung (20), umfassend:
ein Transportmittel (34, 42, 48, 50, 68) zum Transportieren einer Basisfolie (Z);
ein Filmabscheidungsmittel, umfassend ein Materialgas-Einführmittel (52) zum Einführen eines Materialgases, das ein Gas enthält, das Silanradikale bildet, und ein plasmagenerierendes Mittel (54); und
ein Gasfluss-Verursachungsmittel (58) zum Verursachen eines Materialgasflusses in die entgegengesetzte Richtung zur Transportrichtung der Basisfolie,
wobei eine Siliciumnitridschicht auf einer Oberfläche der Basisfolie durch plasmaverstärkte CVD abgeschieden wird,
worin das Gasfluss-Verursachungsmittel ein Materialgas-Blockiermittel (58) umfasst, das auf der nachgeschalteten Seite des Materialgas-Einführmittel im Hinblick auf die Basisfolientransportrichtung angeordnet ist,
worin das Materialgas-Einführmittel auch als Gasfluss-Verursachungsmittel fungiert und worin der Gasfluss durch Einführen von mehr Materialgas auf der nachgeschalteten Seite im Hinblick auf die Basisfolien-Transportrichtung als auf der vorgeschalteten Seite verursacht wird.

7. Filmabscheidungsvorrichtung (20) gemäß Anspruch 6, worin das plasmagenerierende Mittel (54) ein Paar Elektroden umfasst.

8. Filmabscheidungsvorrichtung (20) gemäß Anspruch 7, worin eine von dem Paar Elektroden eine Duschkopfelektrode (46, 46a) mit einer Vielzahl von Gasemissionslöchern für das Materialgas ist.

9. Filmabscheidungsvorrichtung gemäß irgendeinem der Ansprüche 6 bis 8, worin das Gasfluss-Verursachungsmittel eine Auslasspassage (60) zum Ausführen des Materialgases auf der vorgeschalteten Seite eines Materialgas-Einführmittels im Hinblick auf die Basisfolien-Transportrichtung umfasst.

10. Filmabscheidungsvorrichtung gemäß irgendeinem der Ansprüche 6 bis 9, worin die Transportmittel eine zylindrische Walze (42) umfasst, wobei über eine Umfangsfläche hiervon eine lange Länge der Basisfolie (Z) laufengelassen wird, um die Basisfolie in einer Längsrichtung hiervon zu transportieren.

## Revendications

1. Procédé de dépôt de film comprenant les étapes consistant à :
transporter un film de base (Z) dans une direction donnée ;
introduire un gaz de matériau contenant un gaz qui génère des radicaux silane tout en créant un flux de gaz du gaz de matériau dans la direction opposée à la direction de transport de film de base ; et
déposer une couche de nitrure de silicium (12) sur une surface du film de base par dépôt chimique en phase vapeur (DCV) activé par plasma,
dans lequel le flux de gaz est créé en fournissant un moyen de blocage (58) pour bloquer le flux de gaz de matériau sur le côté aval d'une portion d'introduction de gaz de matériau par rapport à la direction de transport de film de base,
dans lequel le flux de gaz est créé en introduisant plus de gaz de matériau côté aval par rapport à la direction de transport de film de base que côté amont.

2. Procédé de dépôt de film selon la revendication 1, dans lequel la couche de nitrure de silicium (12) est déposée par dépôt chimique en phase vapeur à plasma à couplage capacitif (DCV-PCC).

3. Procédé de dépôt de film selon la revendication 2, dans lequel le gaz de matériau est introduit à travers une électrode en pomme de douche (46, 46a) ayant une pluralité de trous d'émission de gaz.

4. Procédé de dépôt de film selon l'une quelconque des revendications 1 à 3, dans lequel le flux de gaz est créé en fournissant un passage de décharge (60) pour décharger le gaz de matériau sur le côté amont d'une portion d'introduction de gaz de matériau (46, 46a) par rapport à la direction de transport de film de base.

5. Procédé de dépôt de film selon l'une quelconque des revendications 1 à 4, dans lequel le dépôt de film est réalisé pendant qu'une longue longueur de film de base (Z) est transportée dans une direction longitudinale.

6. Dispositif de dépôt de film (20) comprenant :
un moyen de transport (34, 42, 48, 50, 68) pour transporter un film de base (Z);
un moyen de dépôt de film incluant un moyen d'introduction de gaz de matériau (52) pour introduire un gaz de matériau contenant un gaz qui génère des radicaux silane et un moyen de génération de plasma (54) ; et
un moyen de création de flux de gaz (58) pour créer un flux de gaz de matériau dans la direction opposée à une direction de transport du film de base,
une couche de nitrure de silicium étant déposée sur une surface du film de base par DCV activé par plasma,
dans lequel le moyen de création de flux de gaz inclut un moyen de blocage de gaz de matériau (58) fourni sur le côté aval du moyen d'introduction de gaz de matériau par rapport à la direction de transport de film de base,
dans lequel le moyen d'introduction de gaz de matériau agit également comme le moyen de création de flux de gaz et dans lequel le flux de gaz est créé en introduisant plus de gaz de matériau côté aval par rapport à la direction de transport de film de base que côté amont.

7. Dispositif de dépôt de film (20) selon la revendication 6, dans lequel le moyen de génération de plasma (54) inclut une paire d'électrodes.

8. Dispositif de dépôt de film (20) selon la revendication 7, dans lequel l'une de la paire d'électrodes est une électrode en pomme de douche (46, 46a) ayant une pluralité de trous d'émission de gaz pour le gaz de matériau.

9. Dispositif de dépôt de film selon l'une quelconque des revendications 6 à 8, dans lequel le moyen de création de flux de gaz inclut un passage de décharge (60) pour décharger le gaz de matériau sur le côté amont d'un moyen d'introduction de gaz de matériau par rapport à la direction de transport de film de base.

10. Dispositif de dépôt de film selon l'une quelconque des revendications 6 à 9, dans lequel le moyen de transport inclut un tambour cylindrique (42) sur une surface périphérique duquel passe une longue longueur de film de base (Z) pour transporter le film de base dans une direction longitudinale de celui-ci.
